Europäisches Patentamt

European Patent Office

Office européen des brevets

(11) Veröffentlichungsnummer: **0 302 124**
**A1**

## (12) EUROPÄISCHE PATENTANMELDUNG

(21) Anmeldenummer: 87111176.1

(22) Anmeldetag: 03.08.87

(51) Int. Cl.⁴: **G03F 7/20**

(43) Veröffentlichungstag der Anmeldung:
**08.02.89 Patentblatt 89/06**

(84) Benannte Vertragsstaaten:
**DE FR GB IT NL**

(71) Anmelder: **PERKIN-ELMER CENSOR ANSTALT**
**Schlossstrasse 5**
**FL-9490 Vaduz(LI)**

(72) Erfinder: **Löbach, Ernst W.**
**Tonagasse 374**
**FL-9492 Eschen(LI)**

(74) Vertreter: **Hofinger, Engelbert et al**
**Torggler-Hofinger Wilhelm-Greil-Strasse 16**
**A-6020 Innsbruck(AT)**

(54) Einrichtung zum Projektionskopieren von Masken auf ein Werkstück.

(57) Einrichtung zum Projektionskopieren von Masken (2) auf ein mit Photolack beschichtetes Halbleitersubstrat (4), mit einer schmalbandiges Licht aussendenden Beleuchtungseinrichtung (1) und mit einem zwischen Maske (2) und Halbleitersubstrat (4) angeordneten Projektionsobjektiv (3), dessen Linsen (3a-d) eine von der Frequenz des verwendeten Lichtes abhängige Brechzahl aufweisen. Es sind eine Einrichtung (5) zur Erfassung der Brechzahl (n) des gasförmigen Umgebungsmediums und eine Frequenzverstelleinrichtung (6) für die Beleuchtungseinrichtung (1) vorgesehen, über die eine Verstellung der Lichtfrequenz in Abhängigkeit von der erfaßten Brechzahl (n) des Umgebungsmediums derart erfolgt, daß das Verhältnis der frequenzabhängigen Brechzahl der Linsen (3a-d) zur Brechzahl (n) des Umgebungsmediums konstant gehalten ist.

Fig. 1

EP 0 302 124 A1

Die Erfindung betrifft eine Einrichtung zum Projektionskopieren von Masken auf ein Werkstück, insbesondere auf ein mit Photolack beschichtetes Halbleitersubstrat, mit einer schmalbandiges Licht aussehenden Beleuchtungseinrichtung und mit einem zwischen Maske und Werkstück angeordneten Projektionsobjektiv, dessen Linse(n) eine von der Frequenz des verwendeten Lichtes abhängige Brechzahl aufweist bzw. aufweisen.

Bei der Projektionslithographie zur Herstellung integrierter Schaltkreise zielen die laufenden Bestrebungen auf immer höhere Integrationsdichten und auf schnellere Herstellungsverfahren ab. Um das beugungsbegrenzte Auflösungsvermögen des verwendeten optischen Systems zu erhöhen, wurde bereits vorgeschlagen, ein im UV-Bereich liegendes Belichtungslicht zu verwenden, dessen Wellenlänge unterhalb der Wellenlänge der bisher üblichen, von Quecksilberlampen erzeugten Belichtungslichter liegt. Abhängig von der numerischen Apertur des Projektionsobjektivs (typisch 0,35 bis 0,45) kann damit ein beugungsbegrenztes Auflösungsvermögen von unter 0,5 $\mu$m erreicht werden, wenn beispielsweise ein KrF-Excimerlaser als Lichtquelle verwendet wird, der 248 nm-Licht emittiert. Damit sind 0,5 $\mu$m Auflösungsvermögen durchaus realistisch.

Es ist klar, daß an das Projektionsobjektiv sehr hohe Qualitätsanforderungen gestellt sein müssen, um über den gesamten Bildbereich eine unverzerrte Abbildung sicherzustellen. Bei Verwendung von Belichtungslicht im tiefen UV-Bereich, das heißt unterhalb von 300 nm, existieren nur wenige geeignete Linsenmaterialien. Als Folge davon können chromatische Korrekturen, die üblicherweise durch Auswahl von Materialien verschiedener Brechzahl durchgeführt werden, nicht vorgenommen werden, so daß äußerst schmalbandiges Belichtungslicht (mit einer Linienbreite von unter 0,01 nm, beispielsweise 0,005 nm) verwendet werden muß.

Eine Einrichtung zum Projektionskopieren, die schmalbandiges Belichtungslicht verwendet und chromatisch unkorrigierte Linsen, also Linsen mit frequenzabhängiger Brechzahl aufweist, ist sehr empfindlich auf Änderungen der Brechzahl der Umgebungsluft, da derartigen Änderungen die optischen Eigenschaften des Projektionsobjektivs, insbesondere dessen Brennweite verändern. Bei Änderungen der Brennweite stört neben dem nötigen Nachführen des Halbleitersubstrates in den Brennpunkt, vor allem die Änderung des Vergrößerungsmaßstabs.

Die Brechzahl der Umgebungsluft variiert hauptsächlich mit der Temperatur und dem Druck. Die Temperatur ist dabei eher unkritisch, weil sie in der Umgebung der Projektionseinrichtung gut regelbar ist. Wesentlich kritischer sind die innerhalb praktischer Grenzen auftretenden Druckschwankungen, aufgrund derer die Brennweite des Projektionsobjektivs und daher die fokale Lage und der Vergrößerungsfaktor des Maskenbildes um nicht tolerierbare Beträge variiert.

Zur Vermeidung von Einflüssen durch Luftbrechzahländerungen hat man bereits vorgeschlagen, das gesamte Strahlvolumen mit Helium zu fluten, wobei man die Tatsache ausnutzt, daß Helium eine nur wenig druckabhängige Brechzahl aufweist. Der Aufwand einer derartigen Methode ist jedoch beträchtlich, zumal eine eigene Helium-Versorgungsanlage benötigt wird. Außerdem geht im Betrieb laufend Helium verloren.

Auch druckluftgefüllte Linsen haben sich wegen der kritischen Abbildungseigenschaften und dem hohen Platzbedarf zum Ausgleich von Brechzahlschwankungen des Umgebungsmediums nicht bewährt.

Andere bekannte Methoden zur Kompensation von Brechzahländerungen des Umgebungsmediums beruhen auf mechanischen Verstellungen im "Wafer Stepper" selbst, wobei zum Wafer Stepper das Projektionsobjektiv, die Maske samt deren Justier- und Halteeinrichtungen sowie das Halbleitersubstrat bzw. Werkstück samt dessen Justier- und Halteeinrichtung, nicht aber die Beleuchtungseinrichtung gezählt wird. Mechanische Verstellungen - sei es der Linsen des Projektionsobjektivs zueinander oder der Maske relativ zum Projektionsobjektiv - können jedoch aufgrund der dabei auftretenden Erschütterungen nur sehr langsam vorgenommen werden. Außerdem nehmen die insbesondere zum gegenseitigen Bewegen der Linsen nötigen Antriebe insgesamt viel Platz und sind sehr aufwendig und ungenau.

Aufgabe der Erfindung ist es, eine Einrichtung zum Projektionskopieren der eingangs genannten Gattung zu schaffen, bei der ohne konstruktive Veränderungen im Bereich des Projektionsobjektivs (das heißt des Wafer Steppers selbst) bzw. ohne zusätzliche Verstellung der bereits üblichen mechanischen Justiereinrichtungen konstante optische Eigenschaften, insbesondere eine konstante Brennweite des Projektionsobjektivs bei Schwankungen der Brechzahl des Umgebungsmediums gegeben ist.

Dies wird erfindungsgemäß dadurch erreicht, daß eine Einrichtung zur Erfassung der Brechzahl des gasförmigen Umgebungsmediums vorgesehen ist und daß die Beleuchtungseinrichtung eine Frequenzverstelleinrichtung aufweist, über die eine Verstellung der Mittenfrequenz des schmalbandigen Lichtes in Abhängigkeit von der erfaßten Brechzahl des Umgebungsmediums derart erfolgt, daß die vom Verhältnis der frequenzabhängigen Brechzahl(en) der Linse(n) zur Brechzahl des Umgebungsmediums abhängige Brennweite des Projektionsobjektivs konstant gehalten ist.

Die Grundidee der Erfindung besteht darin, bei einer Projektionskopiereinrichtung über eine von der erfaßten Brechzahl des Umgebungsmediums abhängige Verstellung der Frequenz des Lichtes, unter Ausnutzung der frequenzabhängigen Brechzahl(en) des Linsenmaterials bzw. der Linsenmaterialien, die von Luft und Brechzahl des Umgebungsmediums abhängige Brennweite des Projektionsobjektivs konstant zu halten. Zusätzliche mechanische Verstellereinrichtungen oder zusätzliche mechanische Verstellungen der bereits vorhandenen Justiereinrichtungen des Wafer-Steppers zur Konstanthaltung der Brennweite sind damit vorteilhafterweise nicht nötig. Im allgemeinen Fall, bei dem die frequenzgängigen Linsen des Projektionsobjektivs verschieden sind und - im Gegensatz zu bisherigen Bestrebungen - insgesamt nicht achromatisch korrigiert sind, ist die Brennweite F eine komplizierte Funktion F (f,n) der Frequenz f und der Brechzahl n des Umgebungsmediums, die sich jedoch sowohl theoretisch als auch meßtechnisch sehr genau bestimmen läßt. Im interessierenden Frequenz- und Brechzahlbereich sind damit auch die partiellen Ableitungen ( $\frac{\partial F}{\partial n}$ ) und ( $\frac{\partial F}{\partial f}$ ) bekannt. Aus der Forderung der Konstanz der Brennweite F (dF = 0) ergibt sich für den zur Kompensation einer Brechzahländerung $\Delta n$ des Umgebungsmediums nötigen Frequenzänderungsbetraf $\Delta f = ( \frac{\partial F}{\partial n} ) / ( \frac{\partial F}{\partial f} ) \bullet \Delta n$.

In jenem bevorzugten Fall, in dem alle Linsen des Projektionsobjektivs aus demselben Material mit frequenzabhängiger Brechzahl bestehen, wobei dann das gesamte Projektionsobjektiv natürlich nichtachromatisch ist, reduziert sich die Konstanthaltung der Brennweite auf die Konstanthaltung des Verhältnisses der frequenzabhängigen Brechzahl des Linsenmaterials zur Brechzahl des Umgebungsmediums.

Die Größe der Frequenzänderung $\Delta f$, die im Fall gleicher Gläser nötig ist, um eine Luftbrechzahländerung $\Delta n$ zu kompensieren, folgt in einfacher Weise aus der Bedingung der Konstanz des Verhältnisses von Luftbrechzahl n zu Linsenbrechzahl n', welche Konstanz gemäß dem Snellius'schen Brechnungsgesetz konstante optische Eigenschaften des Projektionsobjektivs impliziert. Im folgenden wird in Anlehnung an das bevorzugte Umgebungsmedium Luft der Einfachheit halber von der "Luftbrechzahl" die Rede sein, wenngleich auch andere Umgebungsmedien als Luft möglich sind. Für die in der Praxis auftretenden Luftbrechzahländerungen gilt folgender linearer Zusammenhang zwischen $\Delta n$ und $\Delta f$ mit im allgemeinen ausreichender Genauigkeit:

$$\Delta f = f - f_i = \left(\frac{dn'}{df}\right)\Bigg|_{f=f_i}^{-1} \cdot \frac{n'(f_i)}{n} \cdot \Delta n$$

Dabei bedeuten n'(fi) die bei der Frequenz fi vorliegende Linsenbrechzahl,

$$\left(\frac{dn'}{df}\right)\Bigg|_{f=f_i}$$

die Ableitung der Dispersionskurve (Brechzahl n' über Frequenz f) des Linsenmaterials an der Stelle fi und fi selbst jene Anfangsfrequenz, bei der bei den Brechzahlen n'(fi) und n die Brennweite des Projektionsobjektivs stimmt. Die an sich auch in Luft vorhandene Dispersion ist so gering, daß sie - im Gegensatz zur Dispersion im Linsenmaterial - ohne Verlust an Genauigkeit vernachlässigt werden kann. Deshalb ist für die Luftbrechzahl einfach der Buchstabe "n" und nicht "n(fi)" verwendet.

Die Materialkonstanten

$$\left(\frac{dn'}{df}\right)_{f=f_i}$$

und n'(fi) sind bekannte Größen, sodaß aus dem durch die erfindungsgemäß vorgesehene Einrichtung zur Erfassung der Luftbrechzahl erfaßten n bzw. $\Delta n$ aus obigem Zusammenhang sofort jenes $\Delta f$ hervorgeht, das dann zu jener frequenzabhängigen Linsenbrechzahl Anlaß gibt, bei der das Verhältnis n'(fi)/n konstant bleibt.

Obwohl der oben aufgezeigte lineare Zusammenhang zwischen $\Delta f$ und $\Delta n$ momentan ausreichend genau erscheint, besteht grundsätzlich auch die Möglichkeit etwaige Nichtlinearitäten der Dispersionskurve des Linsenmaterials im betrachteten Frequenzintervall zu berücksichtigen.

Wenngleich die Anwendung der Erfindung grundsätzlich nicht auf bestimmte Wellenlängen- bzw. Frequenzbereiche beschränkt ist, so bringt doch die Anwendung im UV-Bereich wegen des Fehlens von chromatisch korrigierten optischen Abbildungselementen in diesem Bereich besondere Vorteile. Eine bevorzugte Ausführungsform der Erfindung besteht demgemäß darin, daß die Beleuchtungseinrichtung eine im ultravioletten Bandbereich des elektromagnetischen Spektrums emittierende, abstimmbare UV-Lichtquelle zur Erzeugung eines für die Projektion verwendeten UV-Lichtes aufweist.

Den Anforderungen an Schmalbandigkeit und ausreichender Abstimmbarkeit wird ein Excimerlaser gerecht, der gemäß einem bevorzugten Merkmal der Erfindung verwendet sein kann. Beispielsweise eignet sich ein KrF-Laser, der - ausgehend von einer Wellenlänge von 248,4 nm - in beide Richtungen um etwa 0,2 nm abstimmbar ist, wobei die Linienbreite des emittierten Lichtes etwa 0,005 nm beträgt.

Zur Abstimmung der Lichtquelle der Beleuchtungseinrichtung ist gemäß einem weiteren bevorzugten Merkmal der Erfindung ein in Abhängigkeit von der ermittelten Brechzahl des Umgebungsmediums (Luft) einstellbarer Wellenlängenselektor vorgesehen, der die natürliche Linienbreite des Belichtungslichtes weiter einengt. Günstig ist beispielsweise ein schwenkbares Echelette-Gitter.

Bei Verwendung eines Echelette-Gitters bzw. eines offenen Fabry-Perot-Etalons zur Festlegung der Frequenz muß darauf bedacht genommen werden, daß diese Elemente eigentlich wellenlängenbestimmende Elemente sind und sich die Wellenlänge mit Luftbrechzahländerungen ebenfalls ändert ($\Delta\lambda = \Delta n/n \cdot \lambda$). Damit bei Luftbrechzahländerungen die Frequenz konstant bleibt, muß bei einer Brechzahländerung $n$ die Wellenlänge $\lambda$ um $\Delta\lambda$ verändert werden, allein um die Luftbrechzahländerung zu kompensieren. Soll nun die Frequenz $f$ gemäß der Erfindung um einen Betrag $f$ (entsprechend einer Wellenlängenänderung $\Delta\lambda_0$) verändert werden, so ist dazu eine gesamte Wellenlängenänderung $\Delta\lambda$ von

$$\Delta\lambda = \Delta\lambda_0 + \Delta\lambda$$

nötig, um tatsächlich bei einer Luftbrechzahländerung $\Delta n$ die gewünschte Frequenzänderung $\Delta f$ zu erhalten. Die zusätzliche Korrektur $\Delta\lambda$ ist natürlich nur dann nötig, wenn sich das Echelette-Gitter bzw. das Etalon im brechzahländerungen unterworfenen Umgebungsmedium befindet.

In der Praxis sind dem Abstimmungsbereich der Beleuchtungseinrichtung bei gleichzeitiger Forderung der extrem schmalen Linienbreite relativ enge Grenzen gesetzt. Um mit einem solchen geringen Abstimmungsbereich die üblich auftretenden Luftbrechzahlschwankungen kompensieren zu können, ist gemäß einem bevorzugten Merkmal der Erfindung vorgesehen, daß die über der Wellenlänge aufgetragene Dispersionskurve der Brechzahl des Linsenmaterials im Bereich des abstimmbaren Wellenlängenbereiches durch eine Gerade approximierbar ist, deren Steigungsbetrag zumindest $10^{-4}\,\text{nm}^{-1}$ beträgt. Wenn hier und im folgenden von Wellenlängen gesprochen wird, so sind damit direkt mit der Frequenz korrelierte Vakuumwellenlängen gemeint, sofern nicht explizit auf Wellenlängen im Medium hingewiesen wird.

Als Alternative zu Excimer-Lasern als durchstimmbare Lichtquelle eignen sich beispielsweise auch Laserdioden oder Festkörperlaser. Um in den UV-Bereich zu gelangen und eine präzise Ausgangsfrequenz zu haben, kann gemäß einem bevorzugten Merkmal der Erfindung vorgesehen sein, daß aus der Laserdiode bzw. dem Festkörper austretende Licht über eine Frequenzvervielfacheranordnung geführt ist, an deren Ausgang eine Frequenzmeßeinrichtung angeordnet ist, und daß eine verstellbare Frequenzregeleinrichtung vorgesehen ist, deren Istwerteingang mit der Frequenzmeßeinrichtung verbunden ist und deren Sollwert in Abhängigkeit von der erfaßten Brechzahl des Umgebungsmediums verstellbar ist. Die Regelung kann über die Temperatur der Lichtquelle erfolgen. Als Frequenzvervielfacher eignen sich zum Beispiel nichtlineare Kristalle in teildurchlässigen konfokalen Resonatoren.

Als Einrichtungen zur Erfassung der Brechzahl des Umgebungsmediums sind gemäß bevorzugtem Merkmal der Erfindung sowohl Absolutrefraktometer, die laufend oder intermittierend den Absolutwert der Brechzahl erfassen, wie auch Differentialrefraktometer, die Änderungen der Brechzahl (abweichend von einem Anfangswert) erfassen.

Eine besonders genaue Erfassung der Luftbrechzahl ist dann möglich, wenn gemäß einem bevorzugten Merkmal der Erfindung die Einrichtung zur Erfassung der Brechzahl des Umgebungsmediums die im Umgebungsmedium momentan vorliegende Wellenlänge eines Lichtstrahles wohldefinierter Frequenz interferometrisch erfaßt und daraus die Brechzahl des Umgebungsmediums ermittelt.

Der dazu nötige Lichtstrahl wohldefinierter Frequenz kommt im allgemeinen aus einem Laser. Derartige Laser stehen bei manchen Projektionsbelichtungseinrichtungen ohnehin zur X-Y-Verstellung des Wafers (Halbleitersubstrat) in Verwendung, womit auch der für das Refraktometer benötigte Lichtstrahl ohne großen Aufwand zur Verfügung steht.

Aus einem Vergleich mit der Vakuumwellenlänge (etwa durch Auspumpen eines eine Referenzstrecke bestimmter Länge definierenden Etalons) kann auf die Luftbrechzahl geschlossen werden. Derartige interferometrische Refraktometer lassen sich auch "differentiell" betreiben, wobei Änderungen der Luftwellenlänge (bei konstanter Frequenz) Änderungen der Luftbrechzahl entsprechen. Ein geeignetes interferometrisches Refraktometer mit einem mit Luftzutrittsöffnungen versehenen Etalon ist beispielsweise das im Handel erhältliche Gerät HP 10717A der Firma Hewlett Packard Co.

Eine etwas gröbere, dafür aber technisch weniger aufwendige Ermittlung der Brechzahl ist gemäß einer bevorzugten Ausführungsform dadurch möglich, daß die Einrichtung zur Erfassung der Brechzahl des Umgebungsmediums einen Temperaturfühler, einen Feuchtigkeitsmesser und ein Barometer aufweist, deren Meßsignale einer elektronischen Auswertschaltung zugeführt sind, die daraus die Brechzahl nach einer vorbestimmten Formel, vorzugsweise der Edlén-Formel, errechnet. Die genannte Edlén-Formel gibt den Absolutwert der Luftbrechzahl als Funktion des Luftdruckes P, der Lufttemperatur T und des Partialdruckes des Wasserdampfes (Feuchte)Pw an:

$$n - 1 = 2{,}8793 \cdot 10^{-7} \frac{P}{1 + 0{,}003671 \cdot T} - 4.2 \cdot 10^{-8} \, P_W$$

Wie bereits erwähnt, bereiten Temperatur und Feuchte im allgemeinen keine wesentlichen Probleme, da diese Werte gut und einfach konstant gehalten werden können.

Hauptsächlich führen also Luftdruckschwankungen zu Luftbrechzahlschwankungen. Es reicht daher gemäß einem bevorzugten Merkmal der Erfindung aus, wenn die Einrichtung zur Erfassung der Brechzahl des Umgebungsmediums von den die Brechzahl an sich beeinflussenden Parametern lediglich den Druck des Umgebungsmediums über ein zugehöriges Barometer erfaßt, dessen Meßsignal einer elektronischen Auswertschaltung zugeführt ist, die daraus und aus den eingespeicherten bzw. eingegebenen Werten für Temperatur und Feuchtigkeit die Brechzahl errechnet.

In der Praxis gibt es eine einfache Version der Regelung, bei der man nicht über die Edlén-Formel o.ä. gehen muß, sondern direkt mit einem Barometersignal z.B. den Drehwinkel eines Echelette-Gitters oder den Piezo-Antrieb eines Fabry-Perot-Resonators steuert. Die Umsetzung Barometersignal-Drehwinkel geschieht dann mit einer empirischen Formel und/oder Kalibrierung. Man nimmt z.B. einen linearen Zusammenhang $p,\phi$ an und eicht etwa bei zwei verschiedenen Drücken $p_1,p_2; |p_1 - p_2| > 50$ mbar. Bei $p_1,\phi_1$ und $p_2,\phi_2$ müssen dann Abbildungsmaßstab und Fokusebene gleich sein.

Vom konstruktiven Aufbau her wird günstigerweise eine Steuereinrichtung vorgesehen sein, deren Eingang mit der Einrichtung zur Erfassung der Brechzahl des gasförmigen Umgebungsmediums und deren Ausgang mit der Frequenzverstelleinrichtung der Beleuchtungseinrichtung verbunden ist und in die dem Frequenzgang der Brechzahl der Linse(n) entsprechende Daten eingespeichert sind.

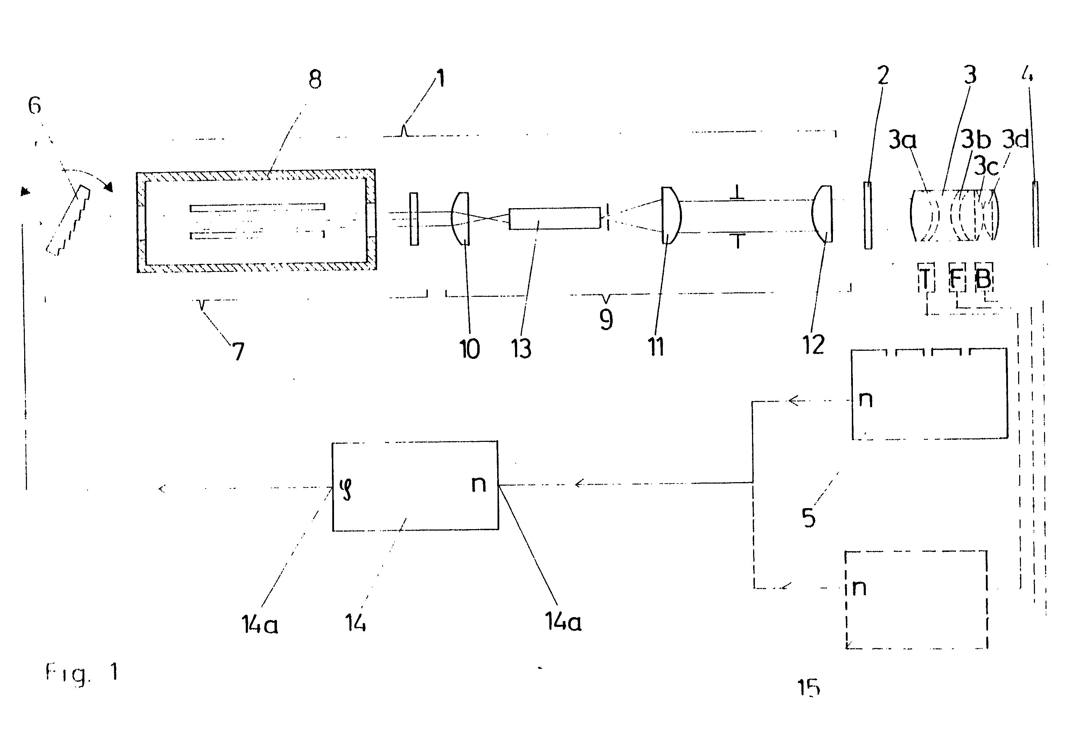

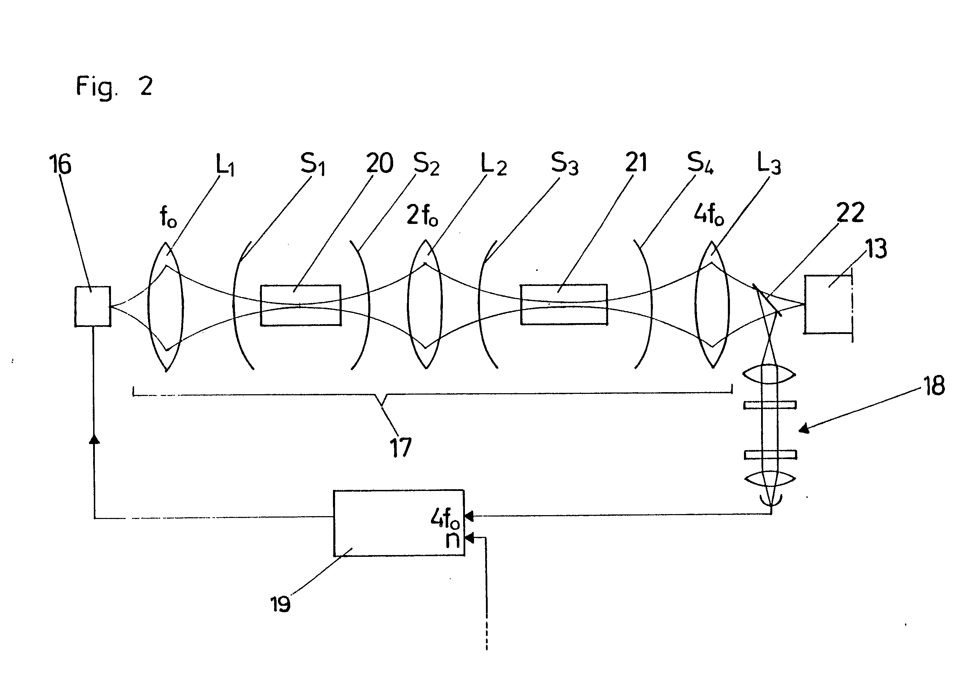

Die Erfindung wird im folgenden anhand von Ausführungsbeispielen durch die Zeichnung näher beschrieben, wobei in Fig.1 ein Ausführungsbeispiel einer erfindungsgemäßen Einrichtung zum Projektionskopieren einer Maske auf ein mit Photolack beschichtetes Halbleitersubstrat und in Fig 2 eine alternativ durchstimmbare Lichtquelle für die Beleuchtungseinrichtung schematisch dargestellt sind.

Die wesentlichen (schematisch dargestellten) Teile sind die allgemein mit 1 bezeichnete Beleuchtungseinrichtung, die abzubildende Maske 2, das verkleinernde Projektionsobjektiv 3, welches die Maske 2 auf ein mit Photolack beschichtetes Halbleitersubstrat 4 abbildet. Erfindungsgemäß ist eine Einrichtung 5 zur Erfassung der Luftbrechzahl n vorgesehen. Weiters weist die Beleuchtungseinrichtung 1 erfindungsgemäß eine (im vorliegenden Fall durch ein schwenkwares Echelette-Gitter 6 gebildete) Frequenzverstelleinrichtung auf, über die eine Verstellung der Mittenfrequenz des schmalbandigen Lichtes in Abhängigkeit von der erfaßten Luftbrechzahl n derart erfolgt, daß das Verhältnis der frequenzabhängigen Brechzahl der hier stark schematisiert dargestellten Linsen 3a-d (alle aus demselben synthetischem Quarz) zur Luftbrechzahl konstant. Damit bleiben die optischen Eigenschaften des Projektionsobjektivs 3, insbesondere dessen Brennweite trotz Luftbrechzahlschwankungen, die beispielsweise durch Luftdruckschwankungen hervorgerufen sind, ohne mechanische Verstellungen im Bereich des Wafer Steppers gleich.

Die Beleuchtungseinrichtung 1 besteht beim vorliegenden Ausführungsbeispiel im wesentlichen aus einer abstimmbaren UV-Lichtquelle 7, die von einem über das Echelette-Gitter abstimmbaren KrF-Excimerlaser 8 gebildet ist, und einem Lichtübertragungssystem 9 zur Aufbereitung des Lichtes für eine gleichmäßige Ausleuchtung des Objektfeldes (Maske 2). Das Lichtübertragungssystem 9 ist für das Verständnis der vorliegenden Erfindung unwesentlich und daher nur kurz beschrieben. Es weist Linsen 10, 11, 12 und einen prismatischen Glasstab 13 auf, in den das Belichtungslicht divergierend eintritt und der eine gleichmäßige Ausleuchtung des Objektfeldes bei der Maske 2 hervorruft.

Die Luftbrechzahl n wird beim vorliegenden Ausführungsbeispiel durch ein interferometrisches Refraktometer 5, beispielsweise vom Typ des HP 10717 A der Firma Hewlett-Packard, ermittelt, wobei als Lichtquelle für den dafür benötigten Lichtstrahl der für die X-Y-Justierung des Wafers 4 vorhandene Laser (nicht dargestellt) verwendet werden kann. Wesentlich ist bei der Verwendung eines interferometrischen Refraktometers, daß auf der Meßstrecke (z.B. ein offenes Etalon), auf der die mit der Brechzahl korrelierte Luftwellenlänge ermittelt wird, im Rahmen der geforderten Genauigkeit dieselben Bedingungen herrschen wie beim Projektionsobjektiv 3.

Beim gezeigten Ausführungsbeispiel ist eine elektronische Steuereinrichtung 14 vorgesehen, deren Eingang 14a mit dem Refraktometer 5 und deren Ausgang 14b mit dem Echelette-Gitter 6 bzw. dessen nicht dargestellten Verstellantrieb verbunden ist. Die Steuereinrichtung 14 errechnet aus den bekannten (beispielsweise eingespeicherten) Werten der Änderung der Linsenbrechzahl mit der Frequenz, der Linsenbrechzahl selbst und dem erfaßten Luftbrechzahlwert n bzw. dessen Veränderung $\Delta n$ ein Steuersignal aus, das einen bestimmten Einstellwinkel des Echelette-Gitters 6 und damit eine bestimmte Frequenz des Belichtungslichtes hervorruft. Bei dieser Frequenz ist dann die Brechzahl des Linsenmaterials gerade so, daß das Verhältnis zur Luftbrechzahl und damit die Brennweite konstant bleibt. Befindet sich das Echelette-Gitter 6 im Umgebungsmedium Luft, so ist bei dessen Verstellung zu beachten, daß sich mit einer Brechzahländerung auch die Luftwellenlänge ändert.

Eine von vielen möglichen Alternativen zu dem mit der Bezugsziffer 5 bezeichneten interferometrischen Refraktometer besteht in einem strichliert gezeichneten Absolutrefraktometer, das einen Temperaturfühler T, einen Feuchtigkeitsmesser F und ein Barometer B aufweist, deren Meßsignale einer Auswertschaltung 15 zugeführt sind, die aus diesen Signalen beispielsweise nach der eingangs genannten Edlén-Formel die momentane Luftbrechzahl errechnet. Sind die Temperatur und die Feuchte im Arbeitsraum gut kontrollierbar, so reicht das Barometer als Meßfühler alleine aus. Die Genauigkeit der Luftbrechzahlbestimmung mit einem interferometrischen Refraktometer 5 ist natürlich höher, dafür ist aber die letztgenannte Variante, die über die Edlén Formel arbeitet, kostengünstiger.

Als praktisches Beispiel kann eine Luftbrechzahländerung von $\Delta n = 10^{-4}$, entsprechend einer Temperaturänderung $\Delta T = \pm 20$ k und $\Delta_p = \pm 100$ m bar, angenommen werden. Für Linsen aus synthetischem Quarz, deren Brechzahl $n'$ um 1,5 liegt, und deren Brechzahländerung mit der Vakuumwellenlänge in der Nähe von 248 nm $-5.5 \cdot 10^{-4}$ $nm^{-1}$ beträgt, ergibt sich eine nötige Wellenlängenänderungen $\Delta\lambda = 0,2742$ nm (bzw. die korrespondierende Frequenzänderung), um beim genannten $\Delta n = 10^{-4}$ immer das Verhältnis $n'/n$ konstant halten zu könner. Dieses $\Delta\lambda$ liegt weit innerhalb der Halbwertsbreite von ca. 0,4 nm des natürlichen Emissionspeaks des KrF-Excimerlaser 8, wobei die Breite dieses Emissionspeaks in etwa dem Abstimmbarkeitsbereich des KrF-Excimerlasers entspricht, der von 248,4 nm um $\pm 0,2$ nm abstimmbar ist, indem durch das schwenkbare Echelette-Gitter 6 eine bestimmte Wellenlänge (eigentlich ein schmaler Wellenlängenbereich) des natürlichen Emissionspeaks ausgewählt wird. Die Linienbreite des so emittierten Lichtes beträgt etwa 0,005 nm.

Die anfängliche Bestimmung der fokalen Lage und des Vergrößerungsfaktors erfolgt über verschiedene Kalibrierungsverfahren, beispielsweise über photolithographische Verfahren, wobei die fokale Lage und der Vergrößerungsfaktor so justiert werden, daß die momentane Luftbrechzahl und die Laserwellenlänge (bzw. Frequenz) in etwa an entsprechenden Stellen in ihren Toleranz- bzw. Abstimmungsbereichen liegen, um den vollen Abstimmbereich des Lasers ausnutzen zu können.

Bei Verwendung eines Absolutrefraktometers muß die Kalibrierung nur beim ersten Justieren der Einrichtung erfolgen. Bei einem Differentialrefraktometer müssen der anfängliche Fokus und der Vergrößerungsfaktor jedes Mal gesetzt werden, nachdem das Refraktometer abgeschaltet worden ist.

In Fig. 2 ist eine alternative durchstimmbare Lichtquellenanordnung zum Excimerlaser 8 der Fig. 1 dargestellt. Als eigentliche Lichtquelle fungiert eine einmodige Hochleistungslaserdiode (Ga Al As) 16, welche im sichtbaren Spektralbereich (z.B. 780 nm) mit geringer spektraler Breite (0,001 bis 0,005 nm) emittiert. Eine allgemein mit 17 bezeichnete Frequenzvervielfacheranordnung erhöht die Frequenz auf das Vierfache bzw. viertelt die Wellenlänge auf beispielsweise 195 nm (UV-Bereich). Die erfindungsgemäße Frequenzverstellung in Abhängigkeit von der Luftbrechzahl erfolgt über eine gezielte Temperaturveränderung der Laserdiode 16. Dabei ist die Frequenz über eine am Ausgang der Frequenzvervielfacheranordnung 17 angeordnete Frequenz- bzw. Wellenlängenmeßeinrichtung 18 (Fabry-Perot-Etalon) und eine Regeleinrichtung 19 geregelt. Der Frequenzsollwert der Regeleinrichtung 19 ist in Abhängigkeit von der Luftbrechzahl n verstellbar.

Die Frequenzvervielfacheranordnung 17 weist Sammellinsen $L_1$, $L_2$ und $L_3$ auf. Die Linse $L_1$ fokussiert den Laseraustritt auf die Mitte des ersten nichtlinearen Kristalls 20. Die Spiegel $S_1$ und $S_2$ bilden einen konfokalen Resonator, um hohe Energiedichten im Kristall 20 zu erzeugen. $S_1$ und $S_2$ haben z.B. 95 % Reflexicen für $f_0$ (Emissionsfrequenz). $S_2$ hat gute Durchlässigkeit für $2 f_0$.

In dem aus $S_3$ und $S_4$ gebildeten zweiten Resonator mit Kristall 21 wiederholt sich die Frequenzverdoppelung, sodaß man letztlich $4 f_0$ erhält. Da z.B. bei $\lambda_0 = 780$ nm das austretende Licht $\lambda_0/4 = 195$ nm als

Wellenlänge hat, müssen der Spiegel $S_4$ und die Linse $L_3$ UV-durchlässig sein.

Eine etwas andere Anordnung erlaubt Frequenz-Verdreifachung. Dann werden im zweiten Kristall 2 $f_0$ und 1 $f_0$ = 3 $f_0$ über eine parametrische Oszillation addiert.

Mögliche Kristallmaterialien sind beispielsweise

KDP = $KH_2PO_4$ = Kaliumdihydrogenphosphat, (AB 220 nm durchlässig)

ADP = $NH_4H_2PO_4$ = Ammoniumdihydrogenphoshpat (AB 200 nm), oder

$\beta$-BBO-$BaB_2O_4$ = $\beta$- Bariumborat (AB 200 nm).

Die spektrale Breite verringert sich günstigerweise noch bei der Frequenzvervielfachung, d.h. die Forderung nach einer geringen, für Nichtachromate geeigneten Bandbreite ist erfüllbar.

Die Kristalle müssen nicht alle aus dem gleichen Material sein. Selbst wenn sie dies sind, bestehen Unterschiede im Kristallschnitt und bei einer Verdreifachung auch in der Achslage. Wichtig ist UV-Transmission für den zweiten Kristall 21. Deswegen wird man bei 4 $f_0$ etwas höher wählen (z.B. 820 nm : 205 nm), bei 3 $f_0$ so niedrig wie möglich (z.B. 780 : 3 = 260 nm). Es gibt heute Kristalle mit sehr guter Ausbeute (~50 %), wenn sie im Resonator betrieben werden.

Die konfokalen Resonatoren werden frequenzmäßig nachgeführt, z.B. mittels thermischer Regelung, damit der Wirkungsgrad hoch bleibt. (3 $f_0$ bzw. 4 $f_0$ ändert sich dadurch nicht).

Wenn die Laserdiode 16 im Dauerstrich betrieben wird, muß zwischen dem Teilerspiegel 22 zum Fabry-Perot 18 und dem Uniformer 13 ein nicht dargestellter Verschluß eingebaut werden.

Anstelle der Laserdiode 16 kann auch ein nicht dargestellter Festkörper-Laser verwendet werden. Beispielsweise eignen sich Chrom-dotierter Alexandrit ($\lambda o$ = 720 nm; $\lambda o/3$ = 240 nm), bei dem die Wellenlänge o durch Temperatur des Kristall-Stabes bestimmt und gestimmt wird; oder Chrom-dotierter Gadolinium-Scandium-Gallium-Granat (GSGG; $\lambda o$ = 836 nm; $\lambda o/4$ = 209 nm).

Die Erfindung ist selbstverständlich nicht auf die gezeigten Ausführungsbeispiele beschränkt. Als Lichtquellen können grundsätzlich auch andere Excimerlaser, Laserdioden oder Festkörperlaser verwendet werden. Allgemein ist jede Beleuchtungseinrichtung möglich, deren Licht die nötige Schmalbandigkeit und gleichzeitig den nötigen Frequenzabstimmungsbereich aufweist. Anstelle des Echelette-Gitters könnte beispielsweise auch ein abstimmbares Fabry-Perot-Etalon verwendet werden. Es ist klar, daß das Projektionsobjektiv 3 nur schematisch dargestellt ist und in der Praxis in Form, Anzahl und Anordnung der Linsen erheblich abweichen kann. Wesentlich ist aber ein Frequenzgang der Brechzahl der Linsen, wobei im allgemeinen Fall die Linsenmaterialien der Linsen nicht gleich sein müssen. Als Linsenmaterialien eignen sich im UV-Bereich beispielsweise Silica- oder Fluorophosphatgläser. Die elektronischen Auswertschaltungen zur Bestimmung der Luftbrechzahl und zur Ermittlung der Signale an die Frequenzverstelleinrichtungen können natürlich alle in einer einzigen Elektronikeinheit integriert sein.

## Ansprüche

1. Einrichtung zum Projektionskopieren von Masken auf ein Werkstück, insbesondere auf ein mit Photolack beschichtetes Halbleitersubstrat, mit einer schmalbandiges Licht aussendenden Beleuchtungseinrichtung und mit einem zwischen Maske und Werkstück angeordneten Projektionsobjektiv, dessen Linse(n) eine von der Frequenz des verwendeten Lichtes abhängige Brechzahl aufweist bzw. aufweisen, dadurch gekennzeichnet, daß eine Einrichtung (5) zur Erfassung der Brechzahl (n) des gasförmigen Umgebungsmediums vorgesehen ist und daß die Beleuchtungseinrichtung (1) eine Frequenzverstelleinrichtung (6) aufweist, über die eine Verstellung der Mittenfrequenz des schmalbandigen Lichtes in Abhängigkeit von der erfaßten Brechzahl (n) des Umgebungsmediums derart erfolgt, daß die vom Verhältnis der frequenzabhängigen Brechzahl(en) der Linse(n) (3a-d) zur Brechzahl (n) des Umgebungsmediums abhängige Brennweite des Projektionsobjektivs (3) konstant gehalten ist.

2. Einrichtung nach Anspruch 1, dadurch gekennzeichnet, daß die Beleuchtungseinrichtung (1) eine im ultravioletten Bandbereich des elektromagnetischen Spektrums emittierende, abstimmbare UV-Lichtquelle (8) zur Erzeugung eines für die Projektion verwendeten UV-Lichtes aufweist.

3. Einrichtung nach Anspruch 2, dadurch gekennzeichnet, daß die abstimmbare UV-Lichtquelle ein Excimerlaser (8) ist.

4. Einrichtung nach Anspruch 3, dadurch gekennzeichnet, daß der Excimerlaser ein KrF-Laser (8) ist, der - ausgehend von einer Wellenlänge von 248,4 nm - in beide Richtungen um etwa 0,2 nm abstimmbar ist, wobei die Linienbreite des emittierten Lichtes etwa 0,005 nm beträgt.

5. Einrichtung nach einem der Ansprüche 1 bis 4, dadurch gekennzeichnet, daß zur Abstimmung der Lichtquelle (8) der Beleuchtungseinrichtung (1) ein in Abhängikeit von der ermittelten Brechzahl (n) des Umgebungsmediums einstellbarer Wellenlängenselektor (6) vorgesehen ist.

6. Einrichtung nach Anspruch 5, dadurch gekennzeichnet, daß der Wellenlängenselektor aus einem schwenkbaren Echelette-Gitter (6) besteht.

7. Einrichtung nach Anspruch 5 oder 6, dadurch gekennzeichnet, daß sich der Wellenlängenselektor (6) im Umgebungsmedium befindet und daß zur Kompensation der durch Brechzahländerungen (n) des Umgebungsmediums hervorgerufenen Wellenlängenänderungen ($\lambda \bullet \Delta n/n$) im Umgebungsmedium die Wellenlänge des Wellenlängenselektors (6) gemäß $\Delta \Lambda = \Delta\lambda_0 + \lambda \bullet \Delta n/n$ verstellt wird, wobei $\Delta\lambda_0$ jene Wellenlängenänderung ist, bei der ohne Wellenlängenänderung aufgrund der Brechzahländerung ($\Delta n$) des Umgebungsmediums die gewünschte Frequenzänderung ($\Delta f$) erfolgte.

8. Einrichtung nach einem der Ansprüche 1 bis 7, dadurch gekennzeichnet, daß alle Linsen (3a-d) des Projektionsobjektivs (3) aus demselben Material bestehen.

9. Einrichtung nach einem der Ansprüche 1 - 8, dadurch gekennzeichnet, daß die Beleuchtungseinrichtung als durchstimmbare Lichtquelle eine Laserdiode oder einen Festkörperlaser aufweist.

10. Einrichtung nach Anspruch 9, dadurch gekennzeichnet, daß das aus der Laserdiode bzw. dem Festkörper austretende Licht über eine Frequenzvervielfacheranordnung geführt ist, an deren Ausgang eine Frequenzmeßeinrichtung angeordnet ist, und daß eine verstellbare Frequenzregeleinrichtung vorgesehen ist, deren Istwerteingang mit der Frequenzmeßeinrichtung verbunden ist und deren Sollwert in Abhängigkeit von der erfaßten Brechzahl des Umgebungsmediums verstellbar ist.

11. Einrichtung nach Anspruch 8,9 oder 10, dadurch gekennzeichnet, daß die Laserlichtquelle temperaturstabilisiert ist und gezielte Frequenzänderungen über Temperaturänderungen erfolgen.

12. Einrichtung nach Anspruch 10 oder 11, dadurch gekennzeichnet, daß die Frequenzvervielfacheranordnung mindestens eine Sammellinse und einen konfokalen Resonator mit einseitig teildurchlässigen Spiegeln aufweist, im Bereich von dessen Brennpunkt ein nichtlinearer Kristall angeordnet ist.

13. Einrichtung nach einem der Ansprüche 1 bis 12, dadurch gekennzeichnet, daß das Linsenmaterial synthetischer Quarz ist.

14. Einrichtung nach einem der Ansprüche 1 bis 13, dadurch gekennzeichnet, daß die über der Wellenlänge aufgetragene Dispersionskurve der Brechzahl des Linsenmaterials im Bereich des abstimmbaren Wellenlängenbereiches durch eine Gerade approximierbar ist, deren Steigungsbetrag zumindest $10^{-4} nm^{-1}$ beträgt.

15. Einrichtung nach einem der Ansprüche 1 bis 14, dadurch gekennzeichnet, daß die Einrichtung zur Erfassung der Brechzahl (n) des Umgebungsmediums ein Absolutrefraktometer (15) zur Erfassung der absoluten Brechzahl (n) des Umgebungsmediums ist.

16. Einrichtung nach einem der Ansprüche 1 bis 15, dadurch gekennzeichnet, daß die Einrichtung (5) zur Erfassung der Brechzahl des Umgebungsmediums ein Differentialrefraktometer ist, mit dem Änderungen der Brechzahl (n) erfaßbar sind.

17. Einrichtung nach einem der Ansprüche 1 bis 16, dadurch gekennzeichnet, daß die Einrichtung (5) zur Erfassung der Brechzahl (n) des Umgebungsmediums die im Umgebungsmedium momentan vorliegende Wellenlänge eines Lichtstrahles wohldefinierter Frequenz interferometrisch erfaßt und daraus die Brechzahl (n) des Umgebungsmediums ermittelt.

18. Einrichtung nach einem der Ansprüche 1 bis 17, dadurch gekennzeichnet, daß die Einrichtung zur Erfassung der Brechzahl (n) des Umgebungsmediums einen Temperaturfühler (T), einen Feuchtigkeitsmesser (F) und ein Barometer (B) aufweist, deren Meßsignale einer elektronischen Auswertschaltung (15) zugeführt sind, die daraus die Brechzahl (n) nach einer vorbestimmten Formel, vorzugsweise der Edlén-Formel, errechnet.

19. Einrichtung nach einem der Ansprüche 1 bis 18, dadurch gekennzeichnet, daß die Einrichtung zur Erfassung der Brechzahl (n) des Umgebungsmediums von den die Brechzahl (n) an sich beeinflussenden Parametern lediglich den Druck des Umgebungsmediums über ein zugehöriges Barometer (B) erfaßt, dessen Meßsignal einer elektronischen Auswertschaltung (15) zugeführt ist, die daraus und aus den eingespeicherten bzw. eingegebenen Werten für Temperatur und Feuchtigkeit die Brechzahl (n) errechnet.

20. Einrichtung nach einem der Ansprüche 1 bis 19, dadurch gekennzeichnet, daß das Umgebungsmedium Luft ist.

21. Einrichtung nach einem der Ansprüche 1 bis 20, dadurch gekennzeichnet, daß eine elektronische Steuereinrichtung (14) vorgesehen ist, deren Eingang (14a) mit der Einrichtung (5) zur Erfassung der Brechzahl (n) des gasförmigen Umgebungsmediums und deren Ausgang (14b) mit der Frequenzverstelleinrichtung (6) der Beleuchtungseinrichtung (1) verbunden ist und in die dem Frequenzgang der Brechzahl der Linse(n) (3a-d) entsprechende Daten eingespeichert sind.

8

Fig. 1

EP 0 302 124 A1

Fig. 2

Europäisches
Patentamt

**EUROPÄISCHER RECHERCHENBERICHT**

Nummer der Anmeldung

EP 87 11 1176

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | DE-A-3 503 273 (CANON) <br> * Seite 8, Zeilen 20-31; Figur 1 * <br> --- | 1 | G 03 F 7/20 |
| A | DE-A-3 318 978 (W. TABARELLI) <br> * Zusammenfassung; Figur 1 * <br> ----- | 1 | |

RECHERCHIERTE SACHGEBIETE (Int. Cl.4)

G 03 F 7/00
G 03 B 41/00

Der vorliegende Recherchenbericht wurde für alle Patentansprüche erstellt

| Recherchenort | Abschlußdatum der Recherche | Prüfer |
|---|---|---|
| DEN HAAG | 22-03-1988 | WITH F.B. |